# EUROPÄISCHE PATENTANMELDUNG

(11) **EP 4 123 701 A1**
(43) Veröffentlichungstag der Anmeldung: **25.01.2023**
(21) Anmeldenummer: 21187079.5
(22) Anmeldetag: 22.07.2021
(51) Int. Cl.: H01L 23/522, H01L 23/48, H01L 23/64, H01L 25/065, H01L 23/495

(54) **ELEKTRONISCHE BAUGRUPPE MIT PRIMÄRSEITE, SEKUNDÄRSEITE UND KOPPLUNGSEINHEIT SOWIE KOPPLUNGSBAUTEIL**

(71) Anmelder: Siemens Aktiengesellschaft, 80333 München (DE)
(72) Erfinder: RAAB, Oliver, 94496 Ortenburg (DE); FISCHER, Peter, 92421 Schwandorf (DE); REISS, Herbert, 92256 Hahnbach (DE); ERNST, Wolfgang, 92245 Kümmersbruck (DE); HAPPEL, Christian, 92245 Kümmersbruck (DE); TAUCHER, Herbert, 1190 Wien (AT)

(57) **Zusammenfassung**

Es wird eine elektronische Baugruppe (1) angegeben mit einer Primärseite (A) und einer Sekundärseite (B), welche durch eine auf einem Kopplungsbauteil (100) bereitgestellte Kopplungseinheit (C) signalübertragend miteinander gekoppelt sind,
- wobei die Baugruppe (1) als Eingangs- und/oder Ausgangsschnittstelle für ein übergeordnetes elektrisches bzw. elektronisches Gerät ausgebildet ist und wenigstens eine der beiden Seiten (A,B) zur digitalen Signalverarbeitung des zu übertragenden Signals ausgelegt ist,
- wobei die Baugruppe (1) wenigstens einen Halbleiterchip (10a,10b) im Bereich der Primär- und/oder Sekundärseite (A,B) aufweist,
- wobei die Kopplungseinheit (C) wenigstens zwei Kondensatoren (120) aufweist, die in separaten Leitungspfaden (L1 bis L8) angeordnet sind und durch die eine galvanische Trennung zwischen Primärseite (A) und Sekundärseite (B) bewirkt wird,
- wobei die wenigstens zwei Kondensatoren (120) der Kopplungseinheit (C) in Schichten auf einem gemeinsamen isolierenden Substrat (110) aufgebaut sind, welches separat von dem Substrat des wenigstens einen Halbleiterchips (10a,10b) gebildet ist,
- und wobei der wenigstens eine Halbleiterchip (10a,10b) und die Kondensatoren (120) der Kopplungseinheit (C) topologisch nebeneinander auf einem übergeordneten Schaltungsträger (20) angeordnet sind.

Weiterhin wird ein Kopplungsbauteil (100) für eine solche Baugruppe (1) angegeben.

## Beschreibung

Die vorliegende Erfindung betrifft eine elektronische Baugruppe mit einer Primärseite und einer Sekundärseite, welche durch eine Kopplungseinheit signalübertragend miteinander gekoppelt sind. Dabei ist die Baugruppe als Eingangs- und/oder Ausgangsschnittstelle für ein übergeordnetes elektrisches bzw. elektronisches Gerät ausgebildet, und wenigstens eine der beiden Seiten ist zur digitalen Signalverarbeitung des zu übertragenden Signals ausgelegt. Die Baugruppe weist hierzu wenigstens einen Halbleiterchip im Bereich der Primär- und/oder Sekundärseite auf. Zwischen der Primär- und der Sekundärseite ist eine galvanische Trennung bewirkt. Weiterhin betrifft die Erfindung ein Kopplungsbauteil für eine solche elektronische Baugruppe.

Aus dem Stand der Technik sind digitale Eingabe- und Ausgabebaugruppen, in denen eine galvanische Trennung zwischen Primär- und Sekundärseite realisiert ist, grundsätzlich bekannt. Beispielsweise kommen solche digitalen Eingabe- und Ausgabebaugruppen in Automatisierungsgeräten zum Einsatz. Dies können insbesondere modulare Automatisierungsgeräte sein, wie sie von der Anmelderin unter der Marke SIMATIC angeboten werden. Aus dieser Palette an Automatisierungsgeräten sind auch als Einzelmodule ausgeführte digitale Eingabebaugruppen und Ausgabebaugruppen bekannt. Diese Eingabe- und Ausgabebaugruppen werden in den Fachkreisen auch als Peripheriebaugruppen bezeichnet, da sie zum Anschluss einer externen Peripherie, also z.B. eines Sensors, vorgesehen sind. Eine solche Peripheriebaugruppe mit einer digitalen Eingabe bzw. Ausgabefunktionalität ist häufig mit einer Mehrzahl von digitalen Eingangskanälen ausgeführt, also z.B. 16 oder 32 digitalen Ein-bzw. Ausgangskanälen.

Die beschriebenen Peripheriebaugruppen weisen allgemein eine Primär- und eine Sekundärseite auf, zwischen denen eine signalübertragende Kopplung realisiert ist. Typischerweise sind diese beiden Seiten voneinander galvanisch getrennt. Eine galvanische Trennung ist notwendig, wenn Stromkreise zwar aufeinander einwirken sollen, ihre Bezugspotentiale jedoch getrennt bleiben sollen. Diese Trennung wird im Wesentlichen aus zwei unterschiedlichen Gründen vorgesehen: Zum einen wird dadurch eine Schutz- bzw. Sicherheitsfunktion bereitgestellt, und zum anderen wird die Störanfälligkeit des übertragenen Signals reduziert. Zum Beispiel kann allgemein eine Vermeidung von Störungen wie "Gleichtakt-Störungen" oder "Ausgleichsströme über Erdschleifen", z.B. bei der Übergabe von Messsignalen, Hochfrequenz- oder Audiosignalen oder bei der Weiterleitung von anderen analogen oder digitalen Signalen, erforderlich sein.

Aus dem Stand der Technik sind verschiedene Möglichkeiten bekannt, eine solche galvanische Trennung umzusetzen:
Einerseits kann eine optisch-elektrische Trennung realisiert sein, z.B. über Optokoppler oder Solid-State Relais. Nachteilig an der Optokoppler-Lösung ist, dass man in der Schaltungsanordnung in der Regel einen zusätzlichen Versorgungsanschluss für einen aktiven Optokoppler benötigt. Eine derzeitige Kunden- bzw. Marktanforderung ist es aber, auf einen zusätzlichen Versorgungsanschluss zu verzichten. Dies hat zur Folge, dass nur Optokoppler ohne eigene Versorgungsspannung verwendet werden können, mit denen aber häufig die Anforderungen an Übertragungsgeschwindigkeit und Jitter nicht bedient werden können. Mit den verfügbaren, integrierten Optokoppler-Lösungen können die genannten Anforderungen an Übertragungsgeschwindigkeit und Jitter typischerweise nur dann erfüllt werden, wenn diese bekannten Schaltungsanordnungen auf der Eingangsseite mit Spannung versorgt werden. Aber ein zusätzlicher Versorgungsanschluss an einer Digitaleingabebaugruppe ist zum einen nicht gewünscht und führt zu einer Inkompatibilität gegenüber den heutigen, diskreten Lösungen und zusätzlich zu einem erhöhten Verdrahtungsaufwand bei einem Kunden. Weitere Nachteile der bekannten Optokoppler-Lösungen sind ein hoher Drift des Übertragungsverhaltens sowie eine beschränkte Lebensdauer.

Alternativ kann die galvanische Trennung induktiv erfolgen, also z.B. über Transformatoren und andere Spulen. Eine weitere Alternative ist schließlich die kapazitive Trennung über ein oder mehrere Kondensatoren.

Bei den bekannten digitalen Ein- und Ausgabebaugruppen sind diese induktiven bzw. kapazitiven galvanischen Trennungen typischerweise in einem der vorhandenen Halbleiterchips integriert. Dies kann prinzipiell ein Halbleiterchip der Primärseite und/oder der Sekundärseite sein. Nachteilig bei einer solchen Chip-Integration ist, dass das galvanisch trennende Element zum Flächenverbrauch der teuren Halbleiterfläche beiträgt und in teuren Spezialprozessen und zum Teil auch mit speziellen Materialien für die Umsetzung der galvanischen Trennung hergestellt wird. Weiterhin muss dann die galvanische Trennung zusammen mit den übrigen funktionalen Elementen des jeweiligen Halbleiterchips entweder auf Chip-Level oder auf Package-Level aufwendig getestet werden, und ein Ausfall in der Funktionalität führt zu einem Ausschuss des gesamten Halbleiterchips. Somit entsteht hier potenziell ein hoher Wertverlust.

Bei allen Lösungen, bei denen die galvanische Trennung relativ viel Fläche verbraucht, also insbesondere bei der Optokoppler- und der induktiven Lösung, entsteht bei einer separaten Ausgestaltung von einer Vielzahl von Signalkanälen ein hoher Flächenbedarf für die Trennung. Dies kann zum Teil mit einer Multiplexer-Schaltung umgangen werden, was aber wiederum an anderer Stelle zu erhöhtem Aufwand und insbesondere zu einer zusätzlichen Spannungsversorgung auf der Signaleingangsseite führt, wie oben im Zusammenhang mit dem Optokoppler beschrieben. Eine galvanische Trennung nicht nur zwischen Primär- und Sekundärseite, sondern auch zwischen den einzelnen Kanälen kann aufgrund dieses hohen Flächenbedarfs häufig nicht realisiert werden.

Aufgabe der Erfindung ist es daher, eine alternative Lösung für die galvanische Trennung in einer Eingangs- und/oder Ausgangsschnittstelle anzugeben, welche die genannten Nachteile überwindet. Insbesondere soll eine Baugruppe zur Verfügung gestellt werden, bei der eine zuverlässige galvanische Trennung mit vergleichsweise geringem Kostenaufwand und gleichzeitig hoher Signalübertragungsrate realisiert werden kann. Weiterhin soll ein Kopplungsbauteil zur Verfügung gestellt werden, welches für eine solche Baugruppe vorgesehen ist.

Diese Aufgaben werden durch die in Anspruch 1 beschriebene elektronische Baugruppe sowie das in Anspruch 14 beschriebene Kopplungsbauteil gelöst. Die erfindungsgemäße Baugruppe weist eine Primärseite und eine Sekundärseite auf, welche durch eine auf einem Kopplungsbauteil bereitgestellte Kopplungseinheit signalübertragend miteinander gekoppelt sind. Die Baugruppe ist insgesamt als Eingangs- und/oder Ausgangsschnittstelle für ein übergeordnetes elektrisches bzw. elektronisches Gerät ausgebildet, und wenigstens eine der beiden Seiten ist zur digitalen Signalverarbeitung des zu übertragenden Signals ausgelegt. Die Baugruppe weist wenigstens einen Halbleiterchip im Bereich der Primär- und/oder Sekundärseite auf. Die Kopplungseinheit weist wenigstens zwei Kondensatoren auf, die in separaten Leitungspfaden angeordnet sind und durch die eine galvanische Trennung zwischen Primärseite und Sekundärseite bewirkt wird. Diese wenigstens zwei Kondensatoren der Kopplungseinheit sind in Schichten auf einem gemeinsamen isolierenden Substrat aufgebaut, welches separat von dem Substrat des wenigstens einen Halbleiterchips gebildet ist. Dabei sind der wenigstens eine Halbleiterchip und die Kondensatoren der Kopplungseinheit topologisch nebeneinander auf einem übergeordneten Schaltungsträger angeordnet.

Die Baugruppe dient also als digitale Eingangs- und/oder Ausgangsschnittstelle in dem Sinne, dass mit ihr digitale Signale in ein übergeordnetes Gerät eingegeben bzw. von einem solchen Gerät ausgegeben werden können. Mit anderen Worten dient die Baugruppe als digitale Schnittstelle für das übergeordnete Gerät. Um diese Schnittstellenfunktion bereitzustellen, kann entweder die Primärseite an eine externe Peripherie angeschlossen werden und die Sekundärseite kann an den Kernteil des übergeordneten Geräts angeschlossen werden oder umgekehrt. In jedem Fall wird die signalübertragende Kopplung zwischen Primär- und Sekundärseite benötigt, um das einzugebende bzw. auszugebende Signal durch die Baugruppe hindurchzuleiten. Zumindest eine der beiden Seiten ist dabei zur digitalen Signalverarbeitung des zu übertragenden Signals ausgelegt und weist hierzu einen Halbleiterchip auf. Es können prinzipiell auch auf beiden Seiten solche Halbleiterchips angeordnet sein. Alternativ oder zusätzlich ist es aber auch möglich, dass auf einer der beiden Seiten eine andere Art von Schaltung, z.B. eine diskret aufgebaute Schaltung zur Signalverarbeitung, vorliegt.

Die Baugruppe wird als digitale Baugruppe bezeichnet, da zumindest auf einer der beiden Seiten ein Chip zur digitalen Signalverarbeitung vorgesehen ist. Dabei soll allerdings das Vorliegen eines analogen Signalanteils nicht ausgeschlossen sein - sowohl auf der Seite des Halbleiterchips als auch auf der anderen Seite, auf der ggf. auch eine diskrete Schaltung vorliegen kann. Prinzipiell können beide Seiten, zumindest auch, zur digitalen Signalverarbeitung vorgesehen sein. Es ist auch möglich, dass eine der beiden Seiten überwiegend zur digitalen Signalverarbeitung und die andere überwiegend zur analogen Signalverarbeitung vorgesehen ist.

Die beschriebene Kopplungseinheit dient sowohl zur signalübertragenden Kopplung als auch zur Umsetzung der galvanischen Trennung zwischen Primär- und Sekundärseite. Diese Funktionalität wird durch ein Kopplungsbauteil bereitgestellt, welches wenigstens ein isolierendes Substrat und wenigstens zwei Kondensatoren umfasst, die durch ein Schichtsystem auf dem isolierenden Substrat gebildet sind. Diese wenigstens zwei Kondensatoren sind in separaten Leitungspfaden angeordnet, so dass zumindest in einer Signalleitung und zumindest in einer Groundleitung (also der Leitung mit dem Bezugspotential für die jeweilige Signalleitung) eine kapazitive galvanische Trennung realisiert ist.

Wesentlich im Zusammenhang mit der vorliegenden Erfindung ist, dass diese Kopplungseinheit nicht in einen der vorhandenen Halbleiterchips integriert ist, sondern dass ihre Funktionalität auf einem separaten Substrat und in einem separaten Kopplungsbauteil bereitgestellt ist. So sind die wenigstens zwei Kondensatoren, mit denen die galvanische Trennung bewirkt wird, auf einem gemeinsamen isolierenden Substrat aufgebaut, welches separat von den Halbleiter-Substraten der Chips gebildet ist.

Unter dem beschriebenen "isolierenden Substrat" soll hier ein funktional isolierendes Substrat verstanden werden. Besonders vorteilhaft kann das Substrat im Wesentlichen aus einem isolierenden Material, insbesondere aus Glas, Keramik oder einem organischen isolierenden Material gebildet sein. Alternativ kann jedoch auch ein Substrat aus einem leitfähigen oder halbleitenden Material zum Einsatz kommen, welches auf der den Kondensatoren zugewandten Seite mit einer elektrisch isolierenden Schicht beschichtet ist, so dass rein funktional ein elektrisch isolierendes Substrat zur Verfügung gestellt wird. Eine solche elektrisch isolierende Schicht kann beispielsweise eine Siliziumdioxid-Schicht oder auch eine Polymerschicht sein. Prinzipiell ist es auch nicht ausgeschlossen, dass das funktional isolierende Substrat an einzelnen Stellen mit leitfähigen Elementen versehen ist, z. B. mit Leiterbahnen und Kontaktflächen, insbesondere in Form von lokalen metallischen Beschichtungen.

Unter dem Merkmal, dass der wenigstens eine Halbleiterchip und die Kondensatoren der Kopplungseinheit "topologisch nebeneinander" auf dem übergeordneten Schaltungsträger angeordnet sind, soll hier verstanden werden, dass die genannten Elemente in unterschiedlichen Bereichen der Oberfläche des übergeordneten Schaltungsträgers angeordnet sind. Sie sollen also nicht in einer gemeinsamen Position übereinander gestapelt sein, sondern in verschiedenen Positionen angeordnet sein. Eine "Position" in diesem Sinne kann ein bestimmter Bereich auf der Oberseite oder auf der Unterseite des Trägersubstrats sein. Mit anderen Worten können also die einzelnen Elemente entweder verschiedene laterale Positionen auf einer gemeinsamen Seite des Schaltungsträgers belegen, oder sie können gegenüberliegend - also teils auf der Oberseite und teils auf der Unterseite des Schaltungsträgers - angeordnet sein, wobei dann auch überlappende laterale Positionen möglich sind. Es soll nur vermieden werden, dass die einzelnen Elemente auf derselben Seite des Schaltungsträgers eine gemeinsame laterale Position einnehmen. In diesem Sinne sind hier die Halbleiterchips und die Kondensatoren "nebeneinander" angeordnet. Auch wenn mehrere Halbleiterchips vorhanden sind, sollen diese "nebeneinander" auf dem Schaltungsträger liegen und nicht ihrerseits auf derselben Schaltungsträgerseite vertikal übereinander gestapelt sein.

Der übergeordnete Schaltungsträger kann beispielsweise ein Trägersubstrat oder ein sogenannter Leadframe sein (also ein Anschlussrahmen), insbesondere ein lötbarer metallischer Leitungsträger in Form eines Rahmens oder Kamms. Der übergeordnete Schaltungsträger kann auch aus mehreren solchen Leadframes zusammengesetzt sein, wobei insbesondere die Halbleiterchips der Primär- und Sekundärseite (soweit beidseitig vorhanden) an separate, aber lateral nebeneinanderliegende Leadframes angebunden sein können.

Der Kerngedanke der vorliegenden Erfindung besteht darin, im Vergleich zum beschriebenen Stand der Technik die Funktionalität der galvanischen Trennung aus den für die digitale Signalverarbeitung vorgesehenen Halbleiterchips auszulagern und diese Funktionalität stattdessen auf einem separaten Substrat bereitzustellen. Ein wesentlicher Vorteil ist, dass die Trennkondensatoren keine teure Halbleiterfläche im Bereich der Chips verbrauchen, sondern als günstigere separate Bauteile zur Verfügung gestellt werden können. Die Aufbautechnik wird dadurch vergleichsweise einfach gehalten, dass die Kondensatoren und die Chips nicht vertikal gestapelt werden, sondern in verschiedenen Bereich der Schaltungsträgeroberfläche topologisch nebeneinander angeordnet sind. Durch die Ausgliederung dieser Funktionalität wird auch ein getrennter Funktionstest der einzelnen Bauteile ermöglicht, und bei einer Fehlfunktion muss nur das jeweils betroffene Bauteil aussortiert werden. Dies reduziert den Wertverlust. Ein weiterer Vorteil liegt darin, dass bei der Ausgestaltung der Trennkondensatoren auf einem separaten isolierenden Substrat eine platzsparende Integration von mehreren Kondensatoren auf einem gemeinsamen Substrat möglich ist, wobei der Gesamt-Flächenbedarf für die Kondensatoren vor allem dadurch gering gehalten werden kann, dass in diesem Bereich andere Materialien und/oder andere Schichtdicken vorgesehen werden als im Schichtsystem der jeweiligen Halbleiterchips. Insbesondere können für die dielektrische Schicht der Kondensatoren auf die Anforderungen der galvanischen Trennung optimierte Eigenschaften gewählt werden, welche unter Umständen mit den Schichtparametern für die dielektrischen Schichten auf den Halbleiterchips nicht kompatibel sind. Mit anderen Worten können die vorhandenen Halbleiterchips und die Kopplungseinheit unabhängig voneinander optimiert werden, was insbesondere zu einer vergleichsweise kompakten Ausgestaltung der Trennkondensatoren auf dem separaten Substrat führen kann. Somit kann auch eine Vielzahl von Signalkanälen auf die beschriebene Weise galvanisch getrennt werden, ohne dass dies zu einem übermäßigen Platzbedarf auf dem übergeordneten Schaltungsträger führt. Insgesamt ermöglicht die Erfindung daher, eine digitale Eingangs- und/oder Ausgangsschnittstelle zu Verfügung zu stellen, bei der eine die galvanische Trennung der Signalkanäle mit vergleichsweise geringem Aufwand und vergleichsweise geringem Platzbedarf realisiert ist, und mit der trotzdem eine hohe Signalübertragungsrate erreicht werden kann.

Das erfindungsgemäße Kopplungsbauteil ist zur Verwendung in einer erfindungsgemäßen elektronischen Baugruppe vorgesehen und stellt das dort beschriebene Kopplungsbauteil dar. Auch dieses Kopplungsbauteil weist eine entsprechende Primärseite und eine Sekundärseite auf, welche durch eine auf dem Kopplungsbauteil bereitgestellte Kopplungseinheit signalübertragend miteinander gekoppelt bzw. koppelbar sind. Das Kopplungsbauteil ist als Eingabe- und/oder Ausgabeschnittstelle für die elektronische Baugruppe ausgebildet. Die Kopplungseinheit weist wenigstens zwei Kondensatoren auf, die in separaten Leitungspfaden angeordnet sind und durch die eine galvanische Trennung zwischen Primärseite und Sekundärseite bewirkt wird. Diese wenigstens zwei Kondensatoren der Kopplungseinheit sind in Schichten auf einem gemeinsamen isolierenden Substrat aufgebaut. Das Kopplungsbauteil weist außerdem wenigstens vier von außen zugängliche elektrische Kontaktstellen auf.

Die Vorteile des erfindungsgemäßen Kopplungsbauteils ergeben sich analog zu den oben beschriebenen Vorteilen der erfindungsgemäßen Baugruppe, insbesondere wenn das Kopplungsbauteil in eine solche Baugruppe eingebaut wird. Die Verbindung des Kopplungsbauteils mit weiteren Elementen der Baugruppe und/oder äußeren Stromkreisen wird durch die genannten wenigstens vier von außen zugänglichen elektrischen Kontaktstellen ermöglicht. Zweckmäßig sind dabei wenigstens zwei Kontaktstellen auf der Primärseite des Kopplungsbauteils und wenigstens zwei Kontaktstellen auf der Sekundärseite des Kopplungsbauteils angeordnet.

Vorteilhafte Ausgestaltungen und Weiterbildungen der Erfindung gehen aus den von Anspruch 1 und Anspruch 14 abhängigen Ansprüchen sowie der folgenden Beschreibung hervor. Dabei können die beschriebenen Ausgestaltungen der elektronischen Baugruppe sowie des Kopplungsbauteils allgemein vorteilhaft miteinander kombiniert werden.

So kann die Kopplungseinheit zur signalübertragenden Kopplung auf einer Mehrzahl n von Signalkanälen ausgelegt sein. Hierzu kann sie eine Anzahl m von wenigstens n+1 Kondensatoren aufweisen, die in n+1 separaten Leitungspfaden angeordnet sind und insbesondere auf einem gemeinsamen isolierenden Substrat aufgebracht sind. Mit anderen Worten kann die Kopplungseinheit eine Vielzahl von einzelnen und jeweils für sich mit einem zugehörigen Kondensator galvanisch getrennten Leitungspfaden aufweisen. Eine Anzahl m der Kondensatoren von m = n+1 ist dabei allgemein ausreichend, wenn n einzelne Signalleitungen und eine gemeinsame Groundleitung vorliegen. Besonders vorteilhaft für eine störungsarme Signalübertragung ist es aber, wenn zu jeder der n Signalleitungen eine eigene zugeordnete Groundleitung vorhanden ist. In diesem Fall ist die Zahl der Kondensatoren und die Anzahl getrennter Leitungspfade zweckmäßigerweise wenigstens m = 2n. Dann kann eine vollständige galvanische Trennung zwischen allen Signalkanälen realisiert werden.

Ein wesentlicher Vorteil von der Implementierung einer Vielzahl von Signalkanälen (unabhängig davon, ob die Groundleitungen gemeinsam oder getrennt realisiert sind) ist, dass damit eine hohe Übertragungsbandbreite erreicht werden kann. Insbesondere kann dann eine hohe Bandbreite ohne eine zusätzliche Multiplexer-Anordnung erreicht werden, und damit kann besonders vorteilhaft auch auf eine zusätzliche Spannungsversorgung auf der Peripherie-Seite der Baugruppe verzichtet werden.

Bei einer vorteilhaften Ausführungsvariante kann die dielektrische Schicht der einzelnen Kondensatoren als gemeinsame übergeordnete Schicht über alle Leitungspfade und insbesondere auch über eine Mehrzahl von Signalkanälen realisiert sein. So kann eine platzsparende Ausführung der Kopplungseinheit erreicht werden, wobei die einzelnen Leitungspfade trotzdem sowohl in sich als auch voneinander galvanisch getrennt sind.

Die Kopplungseinheit kann vorteilhaft entweder für sich allein oder zusammen mit einem oder mehreren Halbleiterchips durch eine Verkapselung gegen die äußere Umgebung gekapselt sein. Eine solche Verkapselung ist zweckmäßig, um das Bauteil vor äußeren Umwelteinflüssen zu schützen. Beispielsweise kann eine solche Verkapselung durch ein Gehäuse oder durch eine Vergussmasse gegeben sein. Ein solches Gehäuse kann beispielsweise ein Spritzgussgehäuse sein. Eine Vergussmasse kann beispielsweise ein sogenannter Glob Top sein.

Bezüglich der Anordnung der Kopplungseinheit auf dem übergeordneten Schaltungsträger ergeben sich unterschiedliche Ausführungsvarianten: Bei einer ersten Ausführungsvariante ist das isolierende Substrat der Kopplungseinheit separat von dem übergeordneten Schaltungsträger ausgeführt und wird von diesem getragen. Bei dieser ersten Ausführungsvariante kann die Verkapselung der Kopplungseinheit beispielsweise separat von einer optional vorhandenen Verkapselung der Halbleiterchips realisiert sein. Mit anderen Worten ist dann jedes Bauteil einzeln gekapselt, wobei aber vorteilhaft die einzelnen Kondensatoren der Kopplungseinheit durch eine gemeinsame Verkapselung gekapselt sind. Alternativ kann hier aber auch eine übergeordnete Verkapselung vorliegen, welche sowohl die Kopplungseinheit als auch die auf demselben Schaltungsträger angeordneten Halbleiterchips gemeinsam gegen die Umgebung kapselt.

Bei einer zweiten Ausführungsvariante für die Anordnung der Kopplungseinheit ist das isolierende Substrat der Kopplungseinheit durch einen Abschnitt des übergeordneten Schaltungsträgers gebildet. Mit anderen Worten bilden das Substrat der Kopplungseinheit und der Schaltungsträger ein gemeinsames übergeordnetes Trägersubstrat. Bei dieser zweiten Ausführungsvariante ist es allgemein bevorzugt, wenn die Kopplungseinheit und die jeweils vorhandenen (ein oder mehreren) Halbleiterchips durch eine gemeinsame Verkapselung geschützt sind.

Bei einer dritten Ausführungsvariante für die Anordnung der Kopplungseinheit liegt eine Mischform vor, bei der zumindest einer der vorhandenen Halbleiterchips zusammen mit den Kondensatoren auf dem isolierenden Substrat der Kopplungseinheit angeordnet ist, bei denen aber trotzdem ein davon separat ausgestalteter Schaltungsträger vorliegt, welcher entweder einen weiteren Halbleiterchip oder andere funktionale Bauelemente trägt. Bei dieser Hybridvariante ist es vorteilhaft, wenn die Kondensatoren zusammen mit dem/den auf demselben isolierenden Substrat angeordneten Halbleiterchip(s) mittels einer gemeinsamen Verkapselung geschützt sind.

Allgemein vorteilhaft und unabhängig von der genauen Ausgestaltungsvariante kann die durch eine solche Verkapselung gebildete Einheit mittels SMD-Kontaktflächen elektrisch kontaktiert bzw. elektrisch kontaktierbar sein. Mit anderen Worten kann die gebildete Verkapselungs-Einheit als oberflächenmontierbares Bauteil ausgestaltet sein (SMD für englisch "Surface-mounted device"). Eine SMD-Kontaktfläche ist eine mit dem SMD-Prozess kompatible, vergleichsweise kleine lötfähige Kontaktfläche. So kann erreicht werden, dass die gekapselte Einheit als SMD-Bauteil relativ platzsparend auf einen übergeordneten Schaltungsträger bestückt werden kann und zwar unabhängig davon, ob die gekapselte Einheit nur die Kopplungseinheit oder auch einen oder mehrere von ihrem isolierenden Substrat getragene Halbleiterchips aufweist.

Allgemein vorteilhaft können die vorhandenen Leiterbahnen und Kontaktflächen des isolierenden Substrats auf der Basis von Kupfer mit einem passenden Haftvermittler oder einem anderen metallischen Schichtsystem gebildet sein. Die Kontaktflächen können insbesondere mit einer lötfähigen bzw. bondfähigen Oberflächenschicht versehen sein, die beispielsweise Gold und/oder Zinn umfasst.

Gemäß einer vorteilhaften Ausführungsform weist die Baugruppe sowohl auf der Primär- als auch auf der Sekundärseite wenigstens einen Halbleiterchip auf, wobei die Kopplungseinheit elektrisch zwischen dem primärseitigen Halbleiterchip und dem sekundärseitigen Halbleiterchip angeordnet ist. Wenn beispielsweise die Baugruppe eine Eingangsschnittstelle für einen Sensor an der Peripherie eines Automatisierungsgeräts bildet, dann es sich bei der Primärseite um die sogenannte "Sensorseite" (oder allgemeiner ausgedrückt, um die "Prozessseite") handeln, und der primärseitige Chip kann ein Empfänger-Chip für das Signal des Sensors sein. In diesen Empfänger-Chip kann auch eine Konstantstrom-Funktionalität integriert sein. Der sekundärseitige Chip kann bei diesem Beispiel ein Auswertungs-Chip zur digitalen Signalverarbeitung des von dem Sensor gemessenen Sensorsignals sein. Es ist jedoch nicht zwingend, dass auf beiden Seiten ein Halbleiterchip vorliegt: So kann insbesondere auch eine der beiden beschriebenen Funktionalitäten in einem diskreten Schaltkreis realisiert sein. Alternativ können von den Schaltungen auf der Primär- bzw. Sekundärseite auch andere Funktionalitäten bereitgestellt werden, insbesondere bei den weiter unten beschriebenen Beispielen, bei denen die Baugruppe als Eingangsschnittstelle für ein Leistungsmodul oder für eine Kommunikationsschnittstelle eines Netzteils ausgestaltet ist. Bei allen denkbaren Anwendungen von digitalen Eingangs- oder Ausgangsschnittstellen ist es jedoch allgemein besonders bevorzugt, wenn beidseitig der Kopplungseinheit zumindest ein Halbleiterchip vorliegt. Für diese Ausführungsform werden im Folgenden unterschiedliche Varianten beschrieben, wie die Halbleiterchips an die dazwischenliegende Kopplungseinheit angebunden sein können.

So können gemäß einer ersten Ausführungsform der wenigstens eine primärseitige Halbleiterchip, das Kopplungsbauteil und der wenigstens eine sekundärseitige Halbleiterchip als separate Bauelemente nebeneinander auf einem gemeinsamen Schaltungsträger angeordnet sein. Diese separaten Bauelemente können insbesondere jeweils für sich gegen die Umgebung gekapselt sein. Bei einer Ausgestaltung des Kopplungsbauteils als SMD-Bauelement kann trotz dieser Trennung eine platzsparende Anordnung auf dem übergeordneten Schaltungsträger realisiert werden, welche bei gleicher Funktionalität nicht viel mehr und unter Umständen sogar weniger Platz beansprucht als eine Integration der galvanischen Trennung auf einem der Halbleiterchips, da der Schichtaufbau des Kopplungsbauteils unabhängig von den Designregeln der jeweiligen Chiptechnologie auf die Anforderungen der Signalübertragung optimiert werden kann.

Gemäß einer alternativen, zweiten Ausführungsform kann entweder der primärseitige Halbleiterchip oder der sekundärseitige Halbleiterchip auf dem isolierenden Substrat des Kopplungsbauteils angeordnet sein, wobei dieses isolierende Substrat und der jeweils andere Halbleiterchip dann nebeneinander auf einem gemeinsamen übergeordneten Schaltungsträger angeordnet sind. Bei dieser Ausführungsform sind die Kopplungseinheit und der auf demselben isolierenden Substrat angeordnete Halbleiterchip bevorzugt durch eine gemeinsame Verkapselung geschützt. Eine besonders platzsparende Anordnung kann hierbei realisiert werden, wenn der Halbleiterchip "face-down", also über seine dem isolierenden Substrat zugewandte Seite, mit diesem verbunden ist, beispielsweise über sogenannte Bump Bonds.

Gemäß einer alternativen, dritten Ausführungsform sind der primärseitige Halbleiterchip und der sekundärseitige Halbleiterchip beide auf dem isolierenden Substrat des Kopplungsbauteils angeordnet. Insbesondere kann das isolierende Substrat des Kopplungsbauteils dann gleichzeitig den übergeordneten Schaltungsträger der Baugruppe bilden. Alternativ kann jedoch auch hier noch ein zusätzlicher übergeordneter Schaltungsträger vorliegen. Grundsätzlich kann die Kontaktierung der Halbleiterchips an das isolierende Substrat hier entweder "face-up" oder "face-down" erfolgen, also beispielsweise über Bonddrähte oder über Bump Bonds. Allgemein ist die "facedown" Variante platzsparender.

Bei dieser Ausführungsform kann das isolierende Substrat des Kopplungsbauteils als sogenannter "Interposer" ausgestaltet sein und beispielsweise im Wesentlichen aus Glas, Keramik oder Silizium aufgebaut sein.

Allgemein vorteilhaft kann die Kopplungseinheit zusammen mit wenigstens einem der vorliegenden Halbleiterchips durch eine Verkapselung gegen die äußere Umgebung gekapselt sein, wobei das isolierende Substrat des Kopplungsbauteils und die einzelnen Halbleiterchips nebeneinander auf dem übergeordneten Schaltungsträger angeordnet sind. Bei dieser Variante ist also das isolierende Substrat separat von dem übergeordneten Schaltungsträger ausgebildet, aber die einzelnen Bauelemente sind trotzdem gemeinsam gekapselt. Diese Variante ist besonders zweckmäßig, wenn der übergeordnete Schaltungsträger als Leadframe ausgestaltet ist. Der übergeordnete Schaltungsträger kann hierbei auch aus mehreren nebeneinanderliegenden Leadframe-Elementen zusammengesetzt sein. Die Kontaktierung zwischen dem Kopplungsbauteil und den einzelnen Halbleiterchips erfolgt bei dieser Variante bevorzugt über obenliegende Bonddrähte, so dass die einzelnen Halbleiterchips also "faceup" auf dem Leadframe angeordnet sind.

Allgemein und unabhängig von der genauen Ausgestaltung des isolierenden Substrats und der einzelnen Bauelemente können die jeweiligen Halbleiterchips auf ihrer vom übergeordneten Schaltungsträger abgewandten Seite über Bonddrähte mit dem übergeordneten Schaltungsträger und/oder mit dem isolierenden Substrat des Kopplungsbauteils und/oder mit separaten Stromzuführungen kontaktiert sein. Mit anderen Worten können die Chips "face-up" kontaktiert sein.

Alternativ können die jeweiligen Halbleiterchips aber auch auf ihrer dem übergeordneten Schaltungsträger zugewandten Seite, insbesondere über Solder Bumps oder Stud Bumps, mit dem Substrat des Kopplungsbauteils und/oder mit dem übergeordneten Schaltungsträger kontaktiert sind. Mit anderen Worten können die Chips "face-down" kontaktiert sein.

Welche Variante für die Chip-Anbindung gewählt wird, hängt von dem Layout der jeweiligen Halbleiterchips, der Art des Schaltungsträgers und dem jeweiligen Platzbedarf bzw. dem vorhandenen Platz auf der zu bestückenden Oberfläche ab.

Gemäß einer allgemein vorteilhaften Ausführungsform können die einzelnen Kondensatoren der Kopplungseinheit eine dielektrische Schicht aufweisen, welche separat von dem isolierenden Substrat gebildet ist und eine Schichtdicke von 100 µm oder weniger aufweist. Es wird bei dieser Ausführungsform also nicht das isolierende Substrat selbst als Dielektrikum genutzt, sonders es liegt zusätzlich zu diesem eine weitere dielektrische Schicht vor. Diese separate dielektrische Schicht kann vergleichsweise dünn ausgestaltet sein, wobei trotzdem eine für die Signalübertragung in digitalen Eingangs- und/oder Ausgangsschnittstellen ausreichende Trennung und Durchschlagfestigkeit - bei gleichzeitig ausreichender Signalübertragung - erreicht werden kann. Hierzu kann die Kapazität der einzelnen Kondensatoren beispielsweise in einem Bereich unterhalb von 10 pF, insbesondere zwischen 1 fF und 1 pF liegen. Die Durchschlagfestigkeit kann vorteilhaft bei wenigstens 700 V liegen, beispielsweise kann die Spezifikation für die Durchschlagfestigkeit in einem Bereich zwischen 700 V und 5000 V liegen. Um eine vorgegebene Durchschlagfestigkeit zu erreichen, können optional auch in jedem Leitungspfad mehrere Kondensatoren in Serie geschaltet sein. Das Material der zusätzlichen dielektrischen Schicht kann beispielsweise eine Keramik bzw. ein Oxid sein (z.B. Siliziumdioxid) oder auch ein Polymer (z.B. ein Polyimid). Die wirksame Fläche der einzelnen Kondensatoren kann beispielsweise in einem Bereich zwischen 200 µm² und 0.25 mm² liegen.

Das isolierende Substrat der Kopplungseinheit kann allgemein vorteilhaft im Wesentlichen aus einem Glas (z.B. BF33 oder AF32) einer Keramik bestehen (z.B. Aluminiumoxid, einer Niedertemperatur-Einbrand-Keramik "LTCC", einer Hochtemperatur-Einbrand-Keramik "HTCC", Aluminiumnitrid oder Siliziumnitrid). Es kann sich aber auch um ein überwiegend organisches elektrisch isolierendes Material handeln. Alternativ zu der oben beschriebenen Ausführungsform mit einer separaten dielektrischen Schicht können die Kondensatoren prinzipiell auch so aufgebaut sein, dass das isolierende Substrat das Dielektrikum ausbildet.

Allgemein kann die elektronische Baugruppe als digitale Eingangs- und/oder Ausgangsschnittstelle für ein Automatisierungsgerät ausgestaltet sein, wie bereits einleitend beschrieben. Insbesondere kann es sich um eine Baugruppe für eine speicherprogrammierbare Steuerung (SPS) handeln, beispielsweise für eine SIMATIC-Baugruppe. Die Primärseite kann dann insbesondere als Prozess- bzw. Sensorseite ausgestaltet sein, und die Sekundärseite kann als Logikseite ausgestaltet sein. Bei dieser Anwendung kommen die Vorteile der vorliegenden Erfindung besonders wirksam zum Tragen.

Alternativ kann die elektronische Baugruppe aber auch als Eingangsschnittstelle für ein Leistungsmodul ausgestaltet sein. Insbesondere kann sie dazu vorgesehen sein, um Steuersignale galvanisch getrennt in die Gate-Treiber eines Leistungsmoduls zu übertragen. Bei einem solchen Leistungsmodul kann es sich beispielsweise um einen Frequenzumrichter handeln, insbesondere um einen Frequenzumrichter der von der Anmelderin unter der Marke SINAMICS vertriebenen Baureihe.

Alternativ kann die elektronische Baugruppe auch als Eingangsschnittstelle für eine Kommunikationsschnittstelle eines Netzteils bzw. einer Stromversorgung ausgestaltet sein. Beispielsweise kann es sich um ein Netzteil der von der Anmelderin unter der Marke SITOP vertriebenen Baureihe handeln.

All den genannten Anwendungen ist gemeinsam, dass ein digital zu verarbeitendes Signal galvanisch getrennt in ein übergeordnetes elektrisches bzw. elektronisches Gerät eingegeben oder aus diesem ausgegeben wird, und dass die vorliegende Erfindung eine Möglichkeit liefert, diese galvanische Trennung vergleichsweise kostengünstig und trotzdem platzsparend zu realisieren, wobei gleichzeitig eine hohe Übertragungsgeschwindigkeit ermöglicht wird.

Ebenso wie bei der übergeordneten Baugruppe kann auch bei dem Kopplungsbauteil die Kopplungseinheit zur signalübertragenden Kopplung auf einer Mehrzahl n von Signalkanälen ausgelegt sein und hierzu eine Anzahl von wenigstens n+1 von Kondensatoren aufweisen, die in separaten Leitungspfaden angeordnet und auf einem gemeinsamen isolierenden Substrat aufgebaut sind. Die Vorteile ergeben sich analog zur entsprechenden Ausführungsform der Baugruppe.

Bezüglich der Ausgestaltung der wenigstens vier Kontaktstellen des Kopplungsbauteils ergeben sich unterschiedliche Varianten: Gemäß einer ersten Ausführungsvariante kann eine Teilmenge (wenigstens zwei) der Kontaktstellen zur Verbindung mit einem primärseitigen Halbleiterchip vorgesehen sein, und eine weitere Teilmenge (wiederum wenigstens zwei) der Kontaktstellen kann zur Verbindung mit einem sekundärseitigen Halbleiterchip vorgesehen sein. Diese Variante ist dann besonders zweckmäßig, wenn das Kopplungsbauteil dazu vorgesehen ist, als separates Bauteil neben den beiden genannten Halbleiterchips auf einem übergeordneten Schaltungsträger angeordnet zu werden.

Gemäß einer alternativen Ausführungsvariante kann wiederum eine Teilmenge (wenigstens zwei) der Kontaktstellen zur Verbindung mit einem primärseitigen Halbleiterchip vorgesehen sein. Auf der Sekundärseite des Kopplungsbauteils kann aber ein Flächenbereich vorgesehen sein, auf dem der sekundärseitige Halbleiterchip mit dem isolierenden Substrat des Kopplungsbauteils verbunden und insbesondere über dort vorhandenen Kontaktflächen kontaktiert werden kann. Die sekundärseitigen von außen zugänglichen Kontaktstellen sind dann in diesem Beispiel (von der Kopplungseinheit aus gesehen) "jenseits" des sekundärseitigen Halbleiterchips angeordnet und dienen der Verbindung dieses Halbleiterchips mit einem außenliegenden Strom- bzw. Signalkreis.

Gemäß einer weiteren Alternative kann die Anordnung auch umgekehrt sein, so dass auf der Sekundärseite des Kopplungsbauteils wenigstens zwei Kontaktstellen zur Verbindung der Kondensatoren mit einem außenliegenden sekundärseitigen Halbleiterchip vorgesehen sind und auf der Primärseite des Kopplungsbauteils ein Flächenbereich zur Bestückung mit einem primärseitigen Halbleiterchip vorhanden ist. In diesem Fall sind dann zweckmäßig auf der Primärseite wenigstens zwei von außen zugängliche Kontaktstellen angeordnet, die (von der Kopplungseinheit aus gesehen) jenseits des primärseitigen Halbleiterchips liegen und der Verbindung dieses Halbleiterchips mit einem außenliegenden Strom- bzw. Signalkreis dienen.

Gemäß einer weiteren Alternative können auch auf beiden Seiten (also auf Primär- und Sekundärseite) entsprechende Flächenbereiche zur Bestückung mit entsprechenden Halbleiterchips vorgesehen sein. Zweckmäßig sind dann auf beiden Seiten die Kontaktflächen zur Verbindung mit äußeren Stromkreisen erst "jenseits" der Chip-Bereiche vorgesehen.

Allgemein und unabhängig von der genauen Anbindung und Anordnung der Kontaktflächen ist es vorteilhaft, wenn das Kopplungsbauteil ein oder mehrere Vias (also elektrische Durchkontaktierungen durch das isolierende Substrat) aufweist, um auf der Substrat-Oberseite angeordnete Elektroden mit auf der Substrat-Unterseite angeordneten Kontaktflächen zu verbinden, oder umgekehrt. Auf diese Weise kann eine kompakte Integration auf einem übergeordneten Schaltungsträger bzw. in einer übergeordneten Baugruppe erreicht werden.

Nachfolgend wird die Erfindung anhand einiger bevorzugter Ausführungsbeispiele unter Bezugnahme auf die angehängten Zeichnungen beschrieben, in denen:
- Figur 1: eine schematische Querschnittdarstellung einer elektronischen Baugruppe nach einem ersten Beispiel der Erfindung zeigt,
- Figur 2: eine Detailansicht eines Kopplungsbauteils für eine solche Baugruppe zeigt,
- Figur 3: eine schematische Aufsicht auf ein solches Kopplungsbauteil zeigt,
- Figur 4: eine schematische Querschnittsdarstellung einer elektronischen Baugruppe nach einem zweiten Ausführungsbeispiel zeigt,
- Figur 5: eine schematische Querschnittsdarstellung einer elektronischen Baugruppe nach einem dritten Ausführungsbeispiel zeigt,
- Figur 6: eine schematische Aufsicht auf das Kopplungsbauteil der Figur 5 zeigt,
- Figuren 7 und 8: weitere Ausführungsbeispiele der Baugruppe im schematischen Querschnitt zeigen und
- Figuren 9 bis 12: weitere Beispiele für mögliche Schichtaufbauten der Kondensatoren in den Kopplungsbauteilen zeigen.

In den Figuren sind gleiche oder funktionsgleiche Elemente mit gleichen Bezugszeichen versehen. Zu beachten ist, dass die Abmessungen in den Figuren nicht maßstabsgetreu sind und dass insbesondere bei realen Bauteilen die Dicke der jeweiligen Substrate typischerweise wesentlich größer ist als die der Leiterbahnen, Elektroden und dielektrischen Schichten.

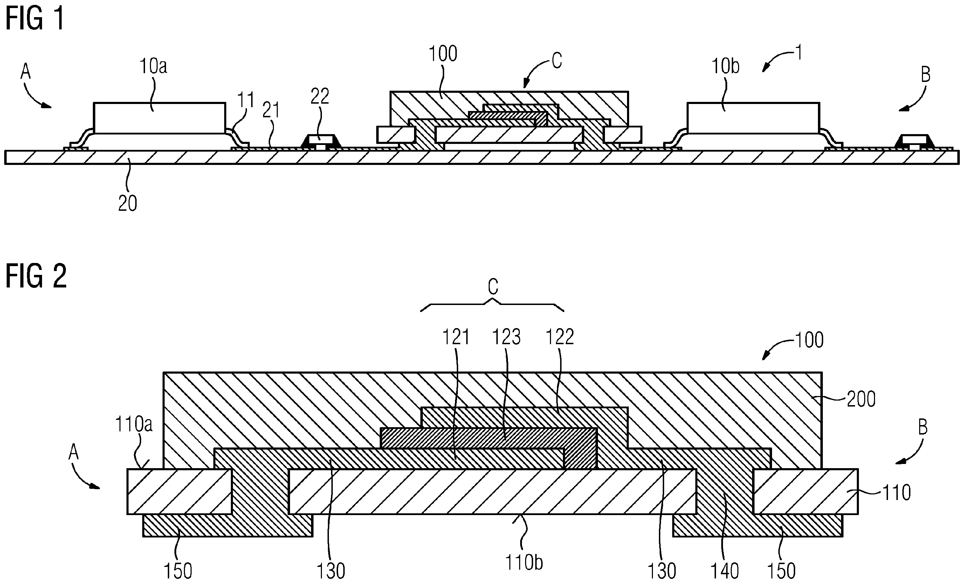

In Figur 1 ist eine elektronische Baugruppe 1 nach einem ersten Beispiel der Erfindung im schematischen Querschnitt gezeigt. Es kann sich dabei um eine ditigale Eingangs- und/oder Ausgangsschnittstelle für ein übergeordnetes Gerät wie z.B. ein Automatisierungsgerät, ein Leistungsmodul oder ein Netzteil handeln. Die Baugruppe 1 weist eine Primärseite A und eine Sekundärseite B auf, zwischen denen durch eine Kopplungseinheit C eine signalübertragende Kopplung realisiert ist. Die Primärseite A kann beispielsweise eine Prozessseite oder eine Sensorseite sein, bei der ein externes Peripheriegerät (z.B. ein Sensor) angeschlossen werden kann. Die Primärseite B kann beispielsweise eine Logikseite sein, auf der eine digitale Signalverarbeitung eines vom Sensor zur Verfügung gestellten Signals erfolgen kann. Im gezeigten Beispiel weist die Baugruppe 1 sowohl einen primärseitigen Halbleiterchip 10a als auch einen sekundärseitigen Halbleiterchip 10b auf, wobei die beiden Halbleiterchips auf einem übergeordneten Schaltungsträger 20 angeordnet sind. Dieser Schaltungsträger kann beispielsweise eine Leiterplatte sein. Die beiden Halbleiterchips 10a, 10b sind hier über Kontaktpins 11 mit entsprechenden Kontaktflächen 21 des Schaltungsträgers 20 elektrisch verbunden und über dort verlaufende und hier nicht näher dargestellte Leiterbahnen mit dem dazwischenliegenden Kopplungsbauteil 100 kontaktiert. Durch dieses Kopplungsbauteil 100 wird die Funktionalität der Kopplungseinheit C bereitgestellt. Optional können auf dem Schaltungsträger 20 auch noch weitere (diskrete oder integrierte) Bauelemente angeordnet sein, was hier beispielhaft durch den als SMD-Bauteil ausgebildeten Widerstand 22 dargestellt ist.

Topologisch zwischen den beiden Halbleiterchips 10a und 10b ist hier also das Kopplungsbauteil 100 angeordnet. Dieses Kopplungsbauteil umfasst ein (funktional) isolierendes Substrat 110, welches separat von den Substraten der beiden Halbleiterchips ausgebildet ist. Beim Beispiel der Figur 1 sind das Kopplungsbauteil 100 und die beiden Halbleiterchips als separate und jeweils separat gekapselte Bauteile nebeneinander auf der Oberfläche des Schaltungsträgers 20 angeordnet. Sie können auch enger miteinander verbunden sein, wie im Zusammenhang mit den nachfolgenden Beispielen noch deutlich werden wird. Wesentlich ist aber, dass die Funktionalität der Kopplungseinheit C aus den Halbleiterchips 10a, 10b ausgelagert ist und dass die Kopplungseinheit C und die Halbleiterchips 10a, 10b topologisch nebeneinander auf der Oberfläche des übergeordneten Schaltungsträgers positioniert sind.

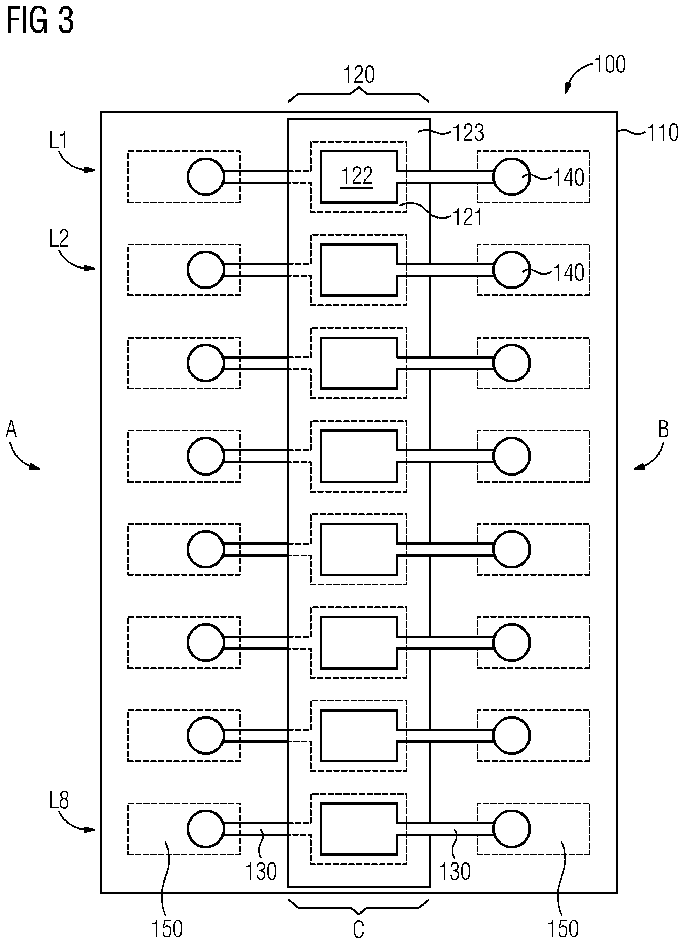

Die Kopplungseinheit C bewirkt zum einen eine signalübertragende Kopplung der beiden Seiten A und B und zum anderen eine galvanische Trennung zwischen ihnen. Um dies zu erreichen, weist die Kopplungseinheit C wenigstens zwei Kondensatoren auf, welche in Form eines Schichtaufbaus auf einem gemeinsamen isolierenden Substrat 110 gebildet sind. Figur 2 zeigt eine Detailansicht des zugehörigen Kopplungsbauteils 100 nach diesem ersten Beispiel der Erfindung, und Figur 3 zeigt eine entsprechende Aufsicht. Wie in Figur 3 zu sehen ist, weist das Kopplungsbauteil 100 mehrere Kondensatoren 120 auf, welche innerhalb der Substratebene nebeneinanderliegen, so dass in den Schnittdarstellungen der Figuren 1 und 2 jeweils nur ein Kondensator 120 zu erkennen ist.

Die einzelnen Kondensatoren 120 sind als Schichtkondensatoren aus jeweils zwei Elektroden 121, 122 und einer dazwischenliegenden dielektrischen Schicht 123 gebildet. Wie aus Figur 3 ersichtlich, nutzen die einzelnen Kondensatoren in diesem Beispiel eine durchgehende übergeordnete Schicht 123 als Dielektrikum. Dies ist jedoch nicht zwingend erforderlich, und die dielektrischen Schichten der einzelnen Kondensatoren können prinzipiell auch getrennt sein. Beim Schichtaufbau der Figur 2 sind sowohl die beiden Elektroden 121, 122 als auch die dielektrische Schicht 123 auf der Substrat-Oberseite 110a angeordnet, welche vom übergeordneten Schaltungsträger 20 abgewandt ist. Um auf der Substrat-Unterseite 110b einen Kontakt mit den entsprechenden Leiterbahnen herstellen zu können, sind die beiden Elektroden 121, 122 jeweils über eine zugeordnete Leiterbahn 130 und ein durch das Substrat 110 hindurchgeführtes Via 140 mit einer SMD-Kontaktfläche 150 auf der Substrat-Unterseite 110b leitend verbunden. Auf der Substrat-Oberseite 110a sind die dort vorliegenden Elemente durch eine Verkapselung 200 gegen die äußere Umgebung geschützt.

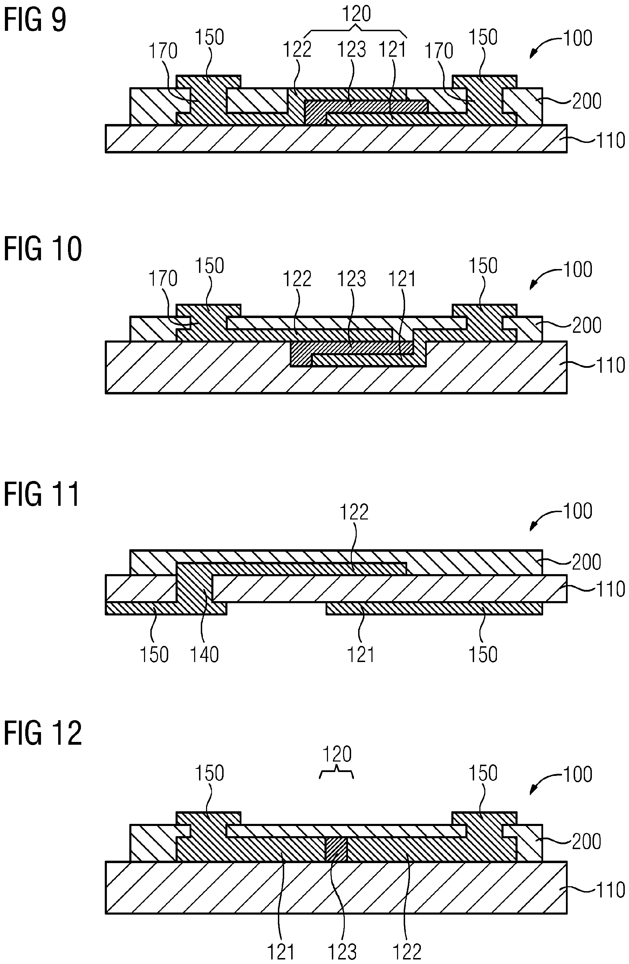

Die Figuren 2 und 3 zeigen jedoch nur ein mögliches Beispiel für die Art des Schichtaufbaus, die Kontaktierung und die Verkapselung. Es sind hier zahlreiche weitere vorteilhafte Varianten denkbar, wie noch im Zusammenhang mit den Figuren 9 bis 12 deutlich werden wird.

In der Aufsichtsdarstellung der Figur 3 wird deutlich, dass bei diesem Beispiel das Kopplungsbauteil 100 (und somit die funktionelle Kopplungseinheit C) acht Kondensatoren 120 in acht separaten Leitungspfaden L1 bis L8 umfasst. Über eine solche Vielzahl m von Kondensatoren kann eine Signalübertragung über eine Mehrzahl n von Signalkanälen ermöglicht werden. Die Beziehung zwischen m und n kann dabei unterschiedlich sein, je nachdem, ob für die einzelnen Signalkanäle gemeinsame oder getrennte Groundleitungen verwendet werden. Bei einer ersten Variante können sich die acht Leitungspfade aus vier einzelnen Signalleitungen und vier jeweils zugeordneten Groundleitungen zusammensetzen. Auf diese Weise kann eine Separierung der Bezugspotentiale und damit eine vollständige Entkopplung der Signalkanäle erreicht werden. Bei einer zweiten Variante können sich die acht Leitungspfade aber auch aus sieben Signalleitungen und einer gemeinsamen Groundleitung zusammensetzen. Dies ermöglicht eine noch höhere Bandbreite, allerdings sind die einzelnen Signalkanäle dann über das gemeinsame Bezugspotential untereinander gekoppelt (auch wenn die Primärseiten von den Sekundärseiten galvanisch getrennt sind). Die gezeigte Anzahl von Leitungspfaden ist auch nur beispielhaft zu verstehen, und es kann auch eine höhere (z.B. 16 oder 32) oder auch eine niedrigere Anzahl von Signalkanälen über die entsprechende Anzahl von Leitungen und Kondensatoren zur Verfügung gestellt werden. Für einen einzelnen Signalkanal werden wenigstens zwei Kondensatoren in zwei separaten Leitungspfaden benötigt, so dass wenigstens vier äußere Kontaktstellen 150 benötigt werden. Für eine Mehrzahl n von Signalkanälen sind es wenigstens n+1 Kondensatoren bzw. Leitungen und damit wenigstens 2(n+1) äußere Kontaktstellen. Bei getrennten Groundleitungen erhöht sich die Zahl der Kondensatoren und Leitungen auf 2n und die Zahl der Kontaktstellen auf 4n.

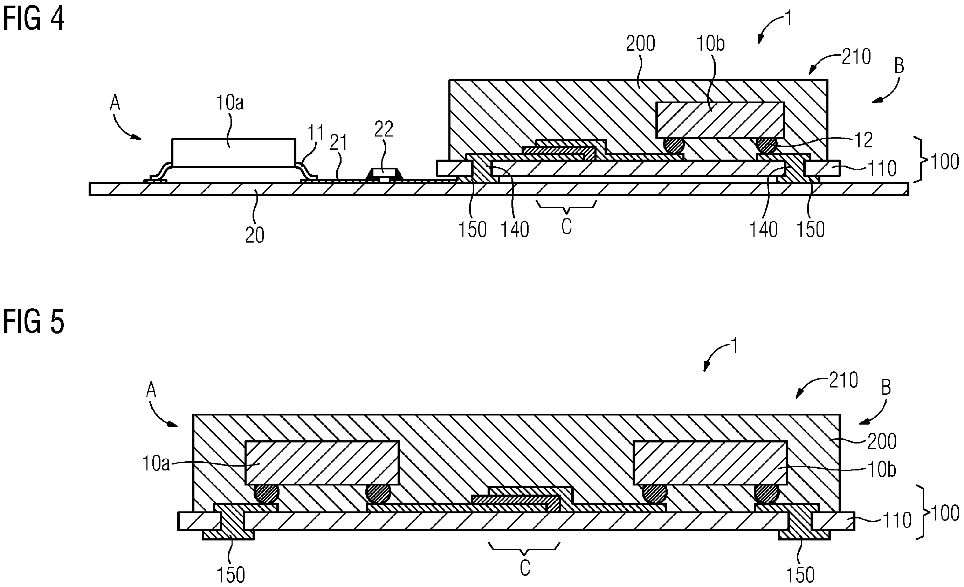

In Figur 4 ist eine schematische Querschnittsdarstellung einer elektronischen Baugruppe 1 nach einem zweiten Ausführungsbeispiel gezeigt. Auch bei diesem Beispiel umfasst die Baugruppe sowohl einen primärseitigen Halbleiterchip 10a als auch einen sekundärseitigen Halbleiterchip 10b und eine topologisch dazwischen angeordnete Kopplungseinheit C. Im Unterschied zum Beispiel der Figur 1 ist das Kopplungsbauteil 100, auf dem die Funktionalität der Kopplungseinheit C bereitgestellt ist, jedoch nicht völlig separat von den Chips auf dem übergeordneten Schaltungsträger 20 angeordnet. Vielmehr wird der sekundärseitige Halbleiterchip 10b von dem isolierenden Substrat 110 des Kopplungsbauteils 100 getragen. Außerdem ist dieser Halbleiterchip 10b zusammen mit den Kondensatoren 120 der Kopplungseinheit C durch eine übergeordnete Verkapselung 200 gekapselt. Dagegen ist der primärseitige Halbleiterchip ähnlich wie beim Beispiel der Figur 1 als separates Bauteil neben dieser gemeinsamen Verkapselungs-Einheit 210 auf dem übergeordneten Schaltungsträger 20 positioniert.

Beim Beispiel der Figur 4 ist der Halbleiterchip 10b über Solder oder Stud Bumps 12 auf seiner untenliegenden Seite mit Metallisierungen des isolierenden Substrats 110 verbunden. Alternativ könnte aber auch die obenliegende Seite des Halbleiterchips 10b über Bonddrähte angebunden sein. Alternativ zu der hier dargestellten Variante, bei der der sekundärseitige Chip von dem Kopplungsbauteil 100 getragen wird, könnte auch der primärseitige Chip 10a von dem Kopplungsbauteil 100 getragen werden, und der sekundärseitige Chip 10b könnte stattdessen separat daneben positioniert sein. In jedem Fall kann durch die Anordnung von wenigstens einem Chip auf dem Substrat des Kopplungsbauteils ein besonders geringer Flächenverbrauch innerhalb der Schaltungsträgerebene erreicht werden.

In Figur 5 ist eine schematische Querschnittsdarstellung einer elektronischen Baugruppe 1 nach einem dritten Ausführungsbeispiel gezeigt. Auch bei diesem Beispiel umfasst die Baugruppe sowohl einen primärseitigen Halbleiterchip 10a als auch einen sekundärseitigen Halbleiterchip 10b und eine topologisch dazwischen angeordnete Kopplungseinheit C. Im Unterschied zu den vorhergehenden Beispielen sind hier jedoch beide Halbleiterchips 10a und 10b auf dem isolierenden Substrat 110 des Kopplungsbauteils 100 angeordnet. Entsprechend sind auch beide Chips 10a und 10b zusammen mit den Kondensatoren der Kopplungseinheit 10 durch eine übergeordnete Verkapselung 200 gegen die Umgebung gekapselt. Hierdurch kann ein noch niedrigerer lateraler Flächenverbrauch erreicht werden. Beim Beispiel der Figur 5 muss nicht zwingend ein zusätzlicher übergeordneter Schaltungsträger vorliegen, sondern diese Funktionalität kann von dem isolierenden Substrat 110 des Kopplungsbauteils erfüllt werden. Alternativ kann dieses isolierende Substrat jedoch auch (z.B. über die untenliegenden SMD-Kontaktflächen 150) mit einem weiteren, hier nicht gezeigten Schaltungsträger verbunden werden. Bei den Beispielen der Figuren 4 und 5, bei denen das isolierende Substrat 110 einen oder mehrere Halbleiterchips sozusagen huckepack trägt, kann das Kopplungsbauteil 100 auch als Interposer bezeichnet werden. In jedem Fall umfasst das Kopplungsbauteil 100 jeweils das isolierende Substrat 110, die darauf angeordneten Kondensatoren 120, Leiterbahnen, Vias und Kontaktflächen - nicht aber die ggf. darauf angeordneten Halbleiterchips, da diese eine separate Funktion erfüllen.

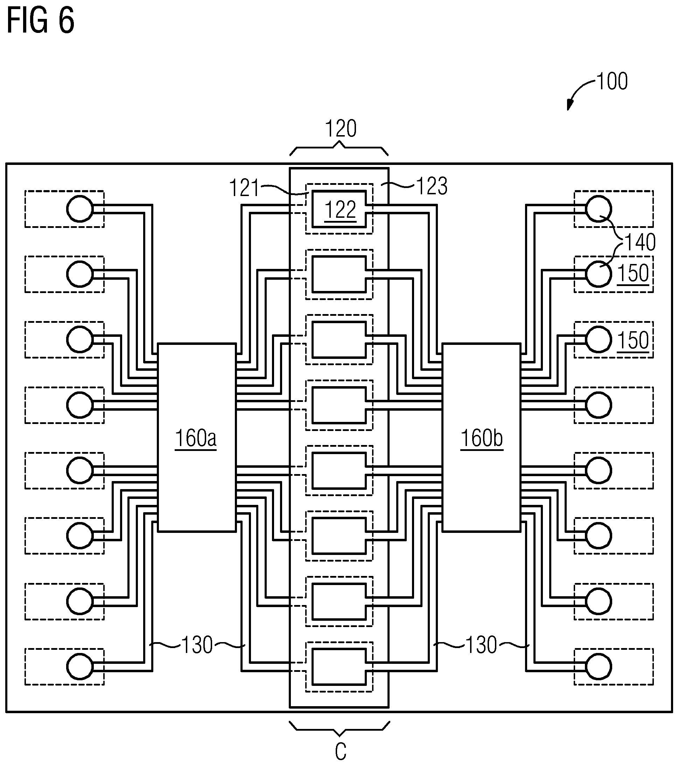

Figur 6 zeigt eine schematische Aufsicht auf das Kopplungsbauteil 100 der Figur 5, das einen Interposer darstellt. Auch hier sind acht Kondensatoren 120 nebeneinander angeordnet, wobei das Dielektrikum wiederum durch eine übergeordnete dielektrische Schicht 123 gebildet ist. Im Unterschied zum Beispiel der Figur 3 sind die einzelnen Kondensatoren aber nicht direkt mit den zugehörigen Kontaktflächen 150 auf der Substrat-Unterseite verbunden, sondern die Kondensatoren 120 sind zunächst über Leiterbahnen 130 mit den beiden Bereichen 160a und 160b verbunden, in denen die Halbleiterchips 10a und 10b in der fertigen Baugruppe angeordnet werden sollen. Erst jenseits des jeweiligen Chips sind die entsprechenden Signal- und Groundleitungen wiederum über einzelne Leiterbahnen 130 und Vias 140 mit den zugehörigen SMD-Kontaktflächen 150 auf der Unterseite des Interposers verbunden. Über diese Kontaktflächen kann die Verbindung zu äußeren Stromkreisen hergestellt werden.

Besonders vorteilhaft bei dieser Interposer-Lösung ist und auch bei der Huckepack-Lösung der Figur 4 ist, dass bei den Halbleiterchips ein wesentlich engeres Anschlussraster gewählt werden kann als bei den äußeren Kontaktflächen 150. Hierdurch können bestehende Halbleiterchips durch ein pinkompatibles Bauteil ersetzt werden, das ein oder mehrere vergleichsweise kleinere Halbleiterchips trägt. Durch die Verwendung von kompakteren Halbleiterchips ohne Änderung des äußeren Anschlussrasters können Fertigungskosten eingespart werden.

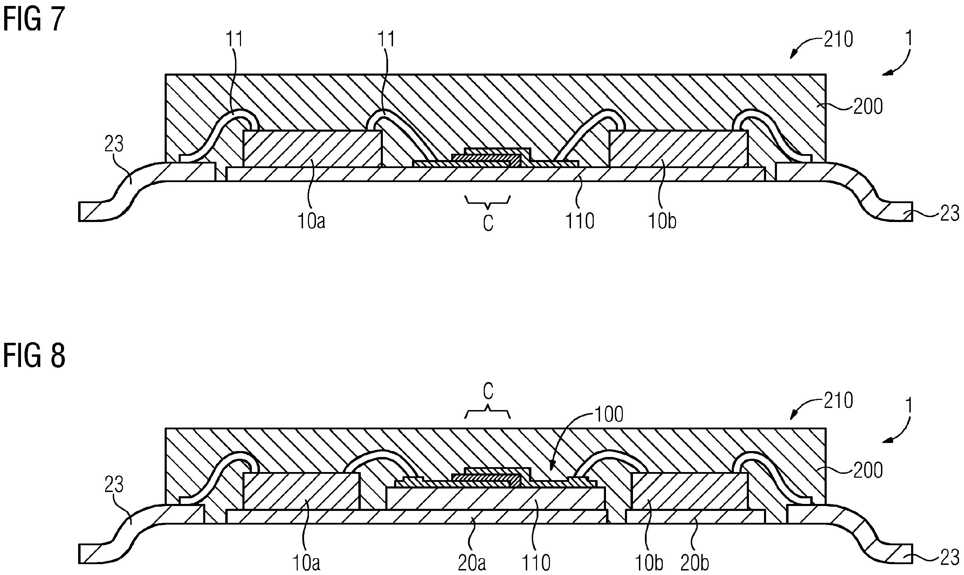

In Figur 7 ist eine schematische Querschnittdarstellung für ein viertes Beispiel der Erfindung gezeigt. Auch in diesem Beispiel werden beide Halbleiterchips 10a und 10b "huckepack" von dem isolierenden Substrat 110 des Kopplungsbauteils getragen, welches gleichzeitig die Funktionalität eines übergeordneten Trägersubstrats bereitstellt. Außerdem sind die beiden Halbleiterchips auch hierzusammen mit den Kondensatoren der Kopplungseinheit mit einer gemeinsamen Verkapselung 200 verkapselt. Im Unterschied zum Beispiel der Figur 5 ist die Kontaktierung der Halbleiterchips 10a und 10b jedoch auf ihrer obenliegenden Seite über Bonddrähte 11 realisiert. Diese Verbindung erfolgt direkt vom Halbleiterchip zum jeweiligen Kondensator, so dass hier gar keine weiteren Leiterbahnen auf dem isolierenden Substrat benötigt werden. Auch auf der von der Kopplungseinheit C abgewandten Seite der Halbleiterchips 10a,10b kann die Anbindung an die hier vorgesehenen außenliegenden Stromzuführungen 23 direkt über Bonddrähte 11 erfolgen.

Figur 8 zeigt ein viertes Ausführungsbeispiel, bei dem ebenfalls eine oberseitige Kontaktierung der beiden Halbleiterchips 10a, 10b mit den Kondensatoren 120 und den außenliegenden Stromzuführungen 23 über Bonddrähte 11 realisiert ist. Auch hier liegt eine übergeordnete Verkapselung 200 für die beiden Halbleiterchips 10a, 10b und die dazwischenliegende Kopplungseinheit C vor. Im Unterschied zum Beispiel der Figur 7 ist hier jedoch das isolierende Substrat 110 des Kopplungsbauteils auf den mittleren Bereich beschränkt, und die beiden Halbleiterchips sind daneben auf einem übergeordneten Schaltungsträger angeordnet. In diesem Beispiel ist der übergeordnete Schaltungsträge als Leadframe ausgebildet und aus zwei Teilelementen 20a und 20b zusammengesetzt, die lateral nebeneinander liegen. Dabei trägt das Teilelement 20a den primärseitigen Halbleiterchip 10a und das Kopplungsbauteil, während das zweite Teilelement 20b den sekundärseitigen Halbleiterchip 20b trägt. Auch hier sind jedoch auch andere Anordnungen und Gruppierungen denkbar. Wesentlich ist nur, dass über den Leadframe keine durchgehende elektrisch leitende Verbindung zwischen Primär- und Sekundärseite erzeugt wird, welche die galvanische Trennung unterlaufen würde.

In den Figuren 9 bis 12 sind schließlich weitere Beispiele für mögliche Schichtaufbauten der Kondensatoren 120 in den Kopplungsbauteilen 100 gezeigt. Auch wenn die gezeigten Kopplungsbauteile jeweils als separate Bauteile dargestellt sind (als Abwandlung der separaten Ausführungsform der Figur 1), so können daraus auch jeweils die entsprechenden Abwandlungen zu den Beispielen der Figuren 4 bis 7 abgeleitet werden, bei denen ein oder mehrere Halbleiterchips von demselben isolierenden Substrat 110 getragen werden, auf dem die Kondensatoren 120 angeordnet sind.

So zeigt Figur 9 einen Aufbau eines Kopplungsbauteils 100, bei dem beide Elektroden 121, 122 und die dielektrische Schicht 123 der jeweiligen Kondensatoren 120 auf der Oberseite des isolierenden Substrats 110 angeordnet sind. Im Unterschied zum Beispiel der Figuren 1 und 2 liegt hier aber keine Durchkontaktierung durch das Substrat 110 vor, sondern die beiden Elektroden sind über Leiterbahnen mit säulenartigen Kontaktstrukturen 170 verbunden, die durch die obenliegende Verkapselung 200 hindurch eine Verbindung zu obenliegenden SMD-Kontaktflächen 150 herstellen. Derartige Säulen 170 können z.B. entweder galvanisch aufgewachsen oder durch eine Bestückung oder Verschweißung angebracht werden.

Figur 10 zeigt einen alternativen Aufbau eines Kopplungsbauteils 100, bei dem das Schichtsystem der Kondensatoren 120 ebenfalls auf der Substratoberseite liegt, bei dem aber jeweils die erste Elektrode 121 und die dielektrische Schicht 123 in eine Kavität des Substrats eingebettet sind. Eine solche Kavität kann beispielsweise durch Ätzen erzeugt werden. Dies hat den Vorteil, dass die säulenartigen Kontaktstrukturen 170 besonders kurz gehalten werden können, z.B. mit einer Höhe zwischen 10 µm und 20 µm, so dass eine kostengünstige Herstellung durch galvanische Prozesse leicht möglich ist.

Figur 11 zeigt einen alternativen Aufbau eines Kopplungsbauteils 100, bei dem die dielektrische Schicht der Kondensatoren durch das isolierende Substrat 110 selbst gebildet ist. Entsprechend ist die erste Elektrode 121 des jeweiligen Kondensators auf der Substrat-Unterseite und die zweite Elektrode 122 auf der Substrat-Oberseite angebracht. Um eine Kontaktierung auf einer gemeinsamen Seite zu ermöglichen, liegt daher jeweils auf der Primärseite ein Via 140 vor, und die Kontaktierung erfolgt bei diesem Beispiel insgesamt über SMD-Kontaktflächen 150 auf der Substrat-Unterseite. Die Kontaktierung kann jedoch alternativ auch auf der Oberseite erfolgen. Auch hier sind die Schichten der Substrat-Oberseite durch eine Verkapselung 200 vor Umgebungseinflüssen geschützt. Wenn das Substrat als Dielektrikum genutzt wird, dann wird aufgrund der vergleichsweise hohen Dicke typischerweise eine schlechtere signalübertragende Kopplung der beiden Seiten erreicht. Dieser Effekt kann ggf. durch vergleichsweise große Elektrodenflächen ausgeglichen, was aber im Vergleich zu einer separaten dielektrischen Schicht zu einem etwas höheren Flächenverbrauch führt.

Figur 12 zeigt einen weiteren alternativen Aufbau des Kopplungsbauteils 100, bei dem die einzelnen Kondensatoren 120 zwar auch durch einen Schichtaufbau auf der Substratoberseite gebildet sind, bei dem aber im Unterschied zu den bisherigen Varianten das Dielektrikum 123 nicht als flächige horizontale Schicht vorliegt, sondern sozusagen als Füllung zwischen zwei lateral beabstandeten Elektroden 121, 122, die innerhalb derselben Schichtebene angeordnet ist. Mit einem solchen lateralen Aufbau können je nach Bedarf andere Durchschlagfestigkeiten und andere geometrische Parameter der einzelnen Kondensatoren 120 eingestellt werden als mit den vertikalen Schichtaufbauten der übrigen Ausführungsbeispiele.

### Bezugszeichenliste

- 1: elektronische Baugruppe
- 10a: primärseitiger Halbleiterchip
- 10b: sekundärseitiger Halbleiterchip
- 11: Kontaktpins
- 12: Solder Bump
- 20: übergeordneter Schaltungsträger
- 20a: erstes Teilelement
- 20b: zweites Teilelement
- 21: Kontaktfläche
- 22: SMD-Bauteil (Widerstand)
- 23: Stromzuführung bzw. Kontaktpin
- 100: Kopplungsbauteil
- 110: isolierendes Substrat
- 110a: Substrat-Oberseite
- 110b: Substrat-Unterseite
- 120: Kondensator
- 121: erste Elektrode
- 122: zweite Elektrode
- 123: dielektrische Schicht
- 130: Leiterbahn
- 140: Via
- 150: SMD-Kontaktfläche
- 160a: Fläche für Chip 10a
- 160b: Fläche für Chip 10b
- 170: Kontaktstruktur
- 200: Verkapselung
- 210: Verkapselungs-Einheit
- A: Primärseite
- B: Sekundärseite
- C: Kopplungseinheit
- L1-L8: Leitungspfade

## Patentansprüche

1. Elektronische Baugruppe (1) mit einer Primärseite (A) und einer Sekundärseite (B), welche durch eine auf einem Kopplungsbauteil (100) bereitgestellte Kopplungseinheit (C) signalübertragend miteinander gekoppelt sind,
- wobei die Baugruppe (1) als Eingangs- und/oder Ausgangsschnittstelle für ein übergeordnetes elektrisches bzw. elektronisches Gerät ausgebildet ist und wenigstens eine der beiden Seiten (A,B) zur digitalen Signalverarbeitung des zu übertragenden Signals ausgelegt ist,
- wobei die Baugruppe (1) wenigstens einen Halbleiterchip (10a,10b) im Bereich der Primär- und/oder Sekundärseite (A,B) aufweist,
- wobei die Kopplungseinheit (C) wenigstens zwei Kondensatoren (120) aufweist, die in separaten Leitungspfaden (L1 bis L8) angeordnet sind und durch die eine galvanische Trennung zwischen Primärseite (A) und Sekundärseite (B) bewirkt wird,
- wobei die wenigstens zwei Kondensatoren (120) der Kopplungseinheit (C) in Schichten auf einem gemeinsamen isolierenden Substrat (110) aufgebaut sind, welches separat von dem Substrat des wenigstens einen Halbleiterchips (10a,10b) gebildet ist,
- und wobei der wenigstens eine Halbleiterchip (10a,10b) und die Kondensatoren (120) der Kopplungseinheit (C) topologisch nebeneinander auf einem übergeordneten Schaltungsträger (20) angeordnet sind.

2. Elektronische Baugruppe (1) nach Anspruch 1, bei welcher die Kopplungseinheit (C) zur signalübertragenden Kopplung mit einer Mehrzahl n von Signalkanälen ausgelegt ist und hierzu eine Anzahl m von wenigstens n+1 Kondensatoren (120) aufweist, die in separaten Leitungspfaden (L1 bis L8) angeordnet und auf einem gemeinsamen isolierenden Substrat (110) aufgebaut sind.

3. Elektronische Baugruppe (1) nach einem der Ansprüche 1 oder 2, bei welcher die Kopplungseinheit (C) entweder für sich allein oder zusammen mit einem oder mehreren Halbleiterchips (10a,10b) durch eine Verkapselung (200) gegen die äußere Umgebung gekapselt ist.

4. Elektronische Baugruppe (1) nach Anspruch 3, wobei die durch die Verkapselung gebildete Einheit (210) mittels SMD-Kontaktflächen (150) elektrisch kontaktiert bzw. kontaktierbar ist.

5. Elektronische Baugruppe (1) nach einem der vorhergehenden Ansprüche, welche sowohl auf der Primär- (A) als auch auf der Sekundärseite (B) wenigstens einen Halbleiterchip (10a,10b) aufweist, wobei die Kopplungseinheit (C) elektrisch zwischen dem primärseitigen Halbleiterchip (10a) und dem sekundärseitigen Halbleiterchip (10b) angeordnet ist.

6. Elektronische Baugruppe (1) nach Anspruch 5, bei welcher der wenigstens eine primärseitige Halbleiterchip (10a), das Kopplungsbauteil (100) und der wenigstens eine sekundärseitige Halbleiterchip (10b) als separate Bauelemente nebeneinander auf einem gemeinsamen Schaltungsträger angeordnet sind.

7. Elektronische Baugruppe nach Anspruch 5, bei welcher der primärseitige Halbleiterchip (10a) oder der sekundärseitige Halbleiterchip (10b) auf dem isolierenden Substrat (110) des Kopplungsbauteils (100) angeordnet ist,
wobei dieses isolierende Substrat (110) und der jeweils andere Halbleiterchip (10b,10a) nebeneinander auf einem gemeinsamen Schaltungsträger (20) angeordnet sind.

8. Elektronische Baugruppe nach Anspruch 5, bei welcher der primärseitige Halbleiterchip (10a) und der sekundärseitige Halbleiterchip (10b) auf dem isolierenden Substrat (110) des Kopplungsbauteils (100) angeordnet sind,
- wobei das isolierende Substrat (110) des Kopplungsbauteils (100) gleichzeitig den übergeordneten Schaltungsträger der Baugruppe (1) bildet.

9. Elektronische Baugruppe (1) nach Anspruch 5, bei welcher die Kopplungseinheit (C) zusammen mit einem oder mehreren Halbleiterchips (10a,10b) durch eine Verkapselung (200) gegen die äußere Umgebung gekapselt ist,
- wobei das isolierende Substrat (110) des Kopplungsbauteils (100) und die einzelnen Halbleiterchips (10a,10b) nebeneinander auf dem übergeordneten Schaltungsträger (20) angeordnet sind.

10. Elektronische Baugruppe (1) nach einem der vorhergehenden Ansprüche, bei welcher die einzelnen Kondensatoren (120) eine dielektrische Schicht (123) aufweisen, welche separat von dem isolierenden Substrat (110) gebildet ist und eine Schichtdicke von 100 µm oder weniger aufweist.

11. Elektronische Baugruppe (1) nach einem der vorhergehenden Ansprüche, welche als digitale Eingangs- und/oder Ausgangsschnittstelle für ein Automatisierungsgerät ausgestaltet ist.

12. Elektronische Baugruppe (1) nach einem der Ansprüche 1 bis 10, welche als Eingangsschnittstelle für ein Leistungsmodul ausgestaltet ist.

13. Elektronische Baugruppe (1) nach einem der Ansprüche 1 bis 10, welche als Eingangsschnittstelle für eine Kommunikationsschnittstelle eines Netzteils ausgestaltet ist.

14. Kopplungsbauteil (100) für eine elektronische Baugruppe (1) nach einem der vorhergehenden Ansprüche mit einer Primärseite (A) und einer Sekundärseite (B), welche durch eine auf dem Kopplungsbauteil (100) bereitgestellte Kopplungseinheit (C) signalübertragend miteinander gekoppelt bzw. koppelbar sind,
- wobei das Kopplungsbauteil (100) als Eingabe- und/oder Ausgabeschnittstelle für die elektronische Baugruppe (1) ausgebildet ist,
- wobei die Kopplungseinheit (C) wenigstens zwei Kondensatoren (120) aufweist, die in separaten Leitungspfaden (L1 bis L8) angeordnet sind und durch die eine galvanische Trennung zwischen Primärseite (A) und Sekundärseite (B) bewirkt wird,
- wobei die wenigstens zwei Kondensatoren (120) der Kopplungseinheit (C) in Schichten auf einem gemeinsamen isolierenden Substrat (110) aufgebaut sind
- und wobei das Kopplungsbauteil (100) wenigstens vier von außen zugängliche elektrische Kontaktstellen (150) aufweist.

15. Kopplungsbauteil (100) nach Anspruch 14, bei welchem die Kopplungseinheit (C) zur signalübertragenden Kopplung auf einer Mehrzahl n von Signalkanälen ausgelegt ist und hierzu eine Anzahl von wenigstens n+1 von Kondensatoren (120) aufweist, die in separaten Leitungspfaden (L1 bis L8) angeordnet und auf einem gemeinsamen isolierenden Substrat (110) aufgebaut sind.
